# EUROPÄISCHE PATENTANMELDUNG

(11) **EP 4 227 993 A1**
(43) Veröffentlichungstag der Anmeldung: **16.08.2023**
(21) Anmeldenummer: 22156634.2
(22) Anmeldetag: 14.02.2022
(51) Int. Cl.: H01L 25/065, H01L 23/00, H01L 25/18, H01L 27/06, H01L 25/00

(54) **HALBLEITERBAUELEMENT**

(71) Anmelder: Fraunhofer-Gesellschaft zur Förderung der angewandten Forschung e.V., 80686 München (DE)
(72) Erfinder: Heinig, Andy, 01069 Dresden (DE)
(74) Vertreter: Pfitzner, Hannes

(57) **Zusammenfassung**

Halbleiterbauelement (10, 10', 10") mit folgenden Merkmalen: erster Schaltungslage (12) mit zumindest einer integrierten Schaltung; und zweiter Schaltungslage (14, 14', 14") mit zumindest einer Stromversorgung (14s), die ausgebildet ist, die integrierte Schaltung (12i) mit elektrischer Energie zu versorgen; wobei eine zweite Hauptoberfläche (12h2) der ersten Schaltungslage (12) mit einer ersten oder zweiten Hauptoberfläche (14h2) der zweiten Schaltungslage (14, 14', 14") verbunden ist.

## Beschreibung

Ausführungsbeispiele der vorliegenden Erfindung beziehen sich auf ein Halbleiterbauelement, insbesondere auf eines mit 3D-Integration-Face-to-Face-Stromversorgung. Weitere Ausführungsbeispiele beziehen sich auf ein entsprechendes Herstellungsverfahren.

Bisher wird die Stromversorgung eines integrierten Schaltkreises bzw. allgemein eines Schaltkreises oder eines 3D-Stapels von Schaltkreisen durch externe Stromversorgung, wie z. B. DC-DC-Konvertern oder durch On-Chip DC-DC-Konverter, realisiert. On-Chip DC-DC-Konverter können sich beispielsweise dann in derselben Schaltungslage oder demselben 3D-Stapel von Schaltungslagen befinden. Bei neusten Schaltkreistechnologien wie z. B. der 3-nm-Technologie sind On-Chip DC-DC-Konverter (technisch) so nicht mehr realisierbar. Hintergrund ist, dass die entsprechenden Transistoren nicht mehr genügend Spannungsfestigkeit und/oder Stromtragfähigkeit besitzen. Auch externe DC-DC-Konverter können nicht mehr die nötige Stabilität der Versorgungsspannung garantieren. Zum Hintergrund: die Versorgungsspannung wurde in den letzten Jahren immer wieder reduziert, wobei die erlaubte Abweichung von der nominalen Versorgungsspannung aber ungefähr gleichgeblieben ist, so dass die Anforderungen an die Gesamtlösung deutlich anstiegen. Dies ist aber mit einer externen Stromversorgung im Regelfall nicht mehr zu realisieren, da dort die Versorgungsleitungen sonst zu lang werden.

Deshalb besteht der Bedarf nach einem verbesserten Ansatz. Die Aufgabe der vorliegenden Erfindung liegt darin, eine Stromversorgung für neueste Schaltkreistechnologien, wie z. B. der 3-nm-Technologie zu schaffen, die die Nachteile in Bezug auf Herstellbarkeit und Versorgungsspannungsstabilität ausräumt oder minimiert.

Die Aufgabe wird durch den Gegenstand der unabhängigen Patentansprüche gelöst.

Ausführungsbeispiele der vorliegenden Erfindung schaffen ein Halbleiterbauelement mit einer ersten Schaltungslage und einer zweiten Schaltungslage. Die erste Schaltungslage weist zumindest eine integrierte Schaltung, wie z. B. einen Speicher und/oder eine Logik auf. Die zweite Schaltungslage weist zumindest eine Stromversorgung auf, die ausgebildet ist, die integrierte Schaltung mit elektrischer Energie zu versorgen. Hierbei ist eine zweite Hauptoberfläche der ersten Schaltungslage (z. B. eine Frontseite/Face) mit einer ersten oder zweiten Hauptoberfläche (Front- oder Rückseite (Face oder Back) je nach Ausführungsbeispiel) der zweiten Schaltungslage verbunden.

Ausführungsbeispielen der vorliegenden Erfindung liegt die Erkenntnis zugrunde, dass es durch eine neuartige Package-Technologie wie die 3D-Integration, es möglich ist, sehr kompakte Realisierungen von verschiedenen Komponenten in einem Chipstapel herzustellen. Dazu werden bei der 3D-Integration die Schaltkreise übereinander gestapelt. Innerhalb der ersten Schaltungslage werden die einen oder mehreren Schaltkreise, die mit der eigentlichen Logik- oder Speicherfunktion versehen sind, angeordnet oder als 3D-Stapel aufgebaut. Für diese Schaltungslage bzw. diese Schaltungslagen kann eine neuartige Herstellungstechnologie wie z. B. die 3-nm-Technologie verwendet werden. In einer zweiten Schaltungslage wird dann die zugehörige Stromversorgung angeordnet. Dadurch dass die zwei Schaltungslagen direkt aneinander angrenzen, z. B. mittels Bonden oder unter Verwendung von Copper Pillow verbunden, angeordnet sind, sind die Leitungslängen extrem klein, so dass die Spannungsstabilität entsprechend dem Anwendungsfall erreicht werden kann. Durch die Verwendung einer separaten Schaltungslage kann eine andere Herstellungstechnologie als bei der ersten Schaltungslage verwendet werden, was dann auch die Herstellbarkeit von leistungsfähigen Stromversorgungen begünstigt. Ferner schaffen Ausführungsbeispiele der vorliegenden Erfindung vorteilhafterweise eine Spannungsversorgung, die direkt am Verbraucher realisiert ist.

Entsprechend Ausführungsbeispielen ist die integrierte Schaltung der ersten Schaltungslage (bzw. allgemein die erste Schaltungslage) mit einer ersten Halbleiterherstellungstechnologie (z. B. 3-nm-Technologie) hergestellt, wobei die zumindest eine Stromversorgung der zweiten Schaltungslage oder allgemein die zweite Schaltungslage mit einer zweiten Halbleiterherstellungstechnologie hergestellt ist. Die erste Halbleiterherstellungstechnologie unterscheidet sich von der zweiten Halbleiterherstellungstechnologie. Entsprechend Ausführungsbeispielen kann die erste Halbleiterherstellungstechnologie beispielsweise 3-nm-Technologie oder eine bessere bzw. weitere miniaturisierte Halbleiterherstellungstechnologie umfassen.

Nachfolgend werden drei exemplarische Ausführungsbeispiele für die 3D-Integration erläutert.

Entsprechend einer ersten Variante kann die zweite Schaltungslage mittels Face-to-Back mit der ersten Schaltungslage gekoppelt sein. Hierbei ist dann die erste Hauptoberfläche der zweiten Schaltungslage mit der zweiten Hauptoberfläche der ersten Schaltungslage verbunden.

Entsprechend einer zweiten Variante kann die erste und die zweite Schaltungslage Face-to-Face verbunden sein. Hierbei ist dann die zweite Hauptoberfläche der ersten Schaltungslage mit der zweiten Hauptoberfläche der zweiten Schaltungslage verbunden. Bei diesen zwei Schaltungslagen können beispielsweise die Materialien, insbesondere Halbleitermaterialien der zwei Schaltungslagen in etwa genauso breit sein, so dass sich eine 3D-Struktur einstellt.

Entsprechend einer dritten Variante wäre es auch denkbar, dass die zweite Schaltungslage ein Mold-Material aufweist. Hier sind dann beispielsweise die zwei Schaltungslagen per Face-to-Face mit einem Mold verbunden. Das heißt also, dass wiederum die zweiten Hauptoberflächen der ersten und zweiten Schaltungslage miteinander verbunden sind.

Entsprechend Ausführungsbeispielen ist die Verbindung der zweiten Hauptoberfläche der ersten Schaltungslage mit der ersten oder zweiten Hauptoberfläche der zweiten Schaltungslage eine direkte Verbindung, eine direkt-gebondete Verbindung, eine gebondete Verbindung, eine Verbindung mit einem Kontaktierungskissen oder eine Verbindung mit einem Kupferkontaktierungskissen (copper pillow). Entsprechend Ausführungsbeispielen bedeckt die zweite Schaltungslage die (gesamte) Fläche der ersten Schaltungslage. Anders ausgedrückt heißt das, dass diese zwei Schaltungslagen gleich groß sind. Entsprechend Ausführungsbeispielen weist die zweite Schaltungslage ein Halbleitermaterial über die gesamte Breite der ersten Schaltungslage auf. Entsprechend anderen Ausführungsbeispielen weist die zweite Schaltungslage einen ersten Bereich mit einem Halbleitermaterial und mindesten einen zweiten Bereich mit einem Mold-Material auf. Es können auch mehrere zweite Bereiche, z. B. lateral neben dem Halbleiterbereich vorgesehen sein. Hierbei kann sich beispielsweise der erste und der zweite Bereich über die (gesamte) Breite der ersten Schaltungslage erstrecken. Alternativ kann jeder der zwei Bereiche auch noch Unterbereiche haben, so dass die gesamte Breite durch den ersten und zweiten Bereich mit jeweils einem oder mehreren Unterbereichen ausgeführt ist, wobei die Unterbereiche auch andersartig ausgeführt sein können.

Entsprechend einem weiteren Ausführungsbeispiel weist die erste Hauptoberfläche der zweiten Schaltungslage Kontakte oder eine Kontaktierungsschicht auf, wenn die zweite Hauptoberfläche zur Verbindung mit der ersten Schaltungslage dient. Alternativ weist die zweite Hauptoberfläche der zweiten Schaltungslage Kontakte oder eine Kontaktierungsschicht auf, wenn die erste Hauptoberfläche zur Kontaktierung mit der ersten Schaltungslage dient. Entsprechend Ausführungsbeispielen sind die Kontakte dazu ausgebildet, um mit einer ungeregelten Spannungsquelle verbunden zu werden. Entsprechend Ausführungsbeispielen ist die Stromversorgung ausgebildet, ausgehend von einer anliegenden ungeregelten Spannung einer ungeregelten Spannungsquelle eine geregelte Spannung aufseiten der zweiten Hauptoberfläche der ersten Schaltungslage, d. h. also je nach Aufbau über ihre erste oder zweite Hauptoberfläche bereitzustellen, um die integrierte Schaltung entsprechend mit elektrischer Energie zu versorgen (Stromversorgung).

Entsprechend Ausführungsbeispielen weist die zweite Schaltungslage eine oder mehrere Vias auf, die sich über die Dicke der zweiten Schaltungslage erstrecken und ausgebildet sind, um einen Signalkontakt der integrierten Schaltung zu schaffen. Entsprechend Ausführungsbeispielen können sich die einen oder mehreren Vias durch das Halbleitermaterial der zweiten Schaltungslage oder auch durch ein Mold-Material der zweiten Schaltungslage erstrecken. Insofern ermöglichen diese zwei Ausführungsbeispiele vorteilhafterweise, dass über die der ersten Schaltungslage abgewandte Hauptoberfläche der zweiten Schaltungslage eine Signalkontaktierung der integrierten Schaltung der ersten Schaltungslage erfolgen kann.

Wie oben schon angedeutet, kann jede Schaltungslage eine oder mehrere Ebenen aufweisen, so dass eine 3D-integrierte Schaltung je Schaltungslage geformt ist. Entsprechend Ausführungsbeispielen kann die zweite Hauptoberfläche der ersten Schaltungslage und/oder die zweite Hauptoberfläche der zweiten Schaltungslage eine Umverdrahtungsschicht und/oder eine Bauteilschicht aufweisen. Über diese Umverdrahtungsschicht wird dann beispielsweise die Kontaktierung zu der anderen Schaltungslage hergestellt.

Entsprechend weiteren Ausführungsbeispielen weist das Halbleiterbauelement eine weitere Schaltungslage auf. Diese ist auf einer ersten Hauptoberfläche der ersten Schaltungslage angeordnet. Beispielsweise kann diese weitere Schaltungslage einen integrierten Schaltkreis, eine Logik und/oder einen Speicher aufweisen.

Ein weiteres Ausführungsbeispiele schafft ein Herstellungsverfahren des oben erläuterten Halbleiterbauelements. Das Herstellungsverfahren weist den Schritt des Verbindens der ersten Schaltungslage mit der zweiten Schaltungslage auf. Entsprechend Ausführungsbeispielen kann das Verbinden durch Bonden, direktes Bonden oder Herstellen einer Kontaktierungskissenverbindung oder einer Kupferkontaktierungskissenverbindung erfolgen. Entsprechend Ausführungsbeispielen erfolgt das Verbinden mittels Face-to-Back-Technologie oder Face-to-Face-Technologie.

Ausführungsbeispiele der vorliegenden Erfindung werden anhand der beiliegenden Zeichnungen erläutert. Es zeigen:
- Fig. 1: eine schematische Darstellung eines Halbleiterbauelements in der Schnittdarstellung, das ein Face-to-Back-Anordnung aufweist gemäß Ausführungsbeispielen;
- Fig. 2: eine schematische Darstellung eines Halbleiterbauelements in der Schnittdarstellung, das eine Face-to-Face-Anordnung aufweist, gemäß einem weiteren Ausführungsbeispiel; und
- Fig. 3: eine schematische Darstellung eines Halbleiterbauelements mit einem Mold in der Schnittdarstellung, das eine Face-to-Face-Anordnung aufweist, gemäß einem weiteren Ausführungsbeispiel.

Bevor nachfolgend Ausführungsbeispiele der vorliegenden Erfindung anhand der beiliegenden Zeichnungen erläutert werden, sei darauf hingewiesen, dass gleiche Elemente und Strukturen mit gleichen Bezugszeichen versehen sind, so dass die Beschreibung derer aufeinander anwendbar bzw. austauschbar ist.

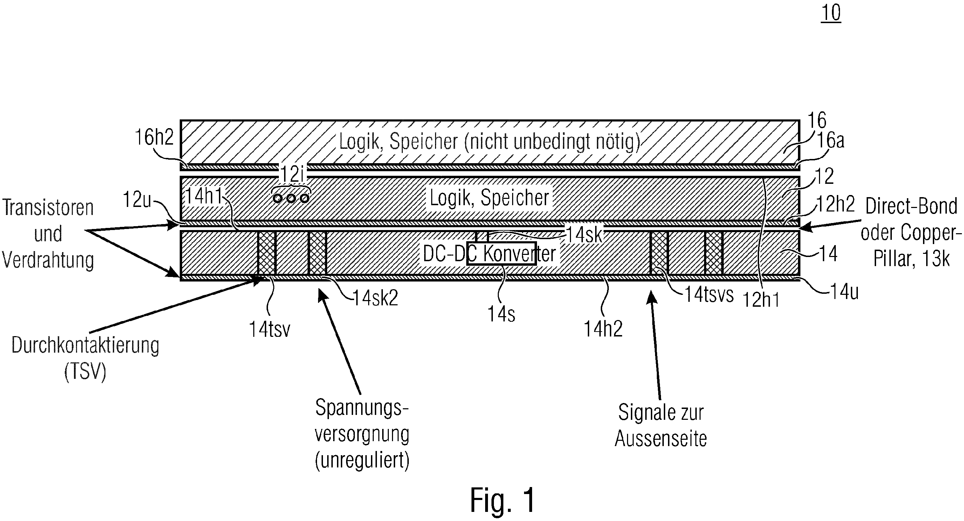

Fig. 1 zeigt ein Halbleiterbauelement 10 mit zumindest zwei Schaltungslagen 12 und 14. Diese zwei Schaltungslagen sind aufeinander, d. h. also direkt angrenzend bzw. miteinander oder sogar direkt miteinander verbunden vorgesehen. Beispielsweise können die zwei Schaltungslagen 12 und 14 eine identische, ähnliche oder zumindest vergleichbare Breite aufweisen, und formen zusammen einen Chip bzw. ein Halbleiterbauelement 10. Optional kann auch noch eine dritte Schaltungslage 16 vorgesehen sein, auf die im Zusammenhang mit dem Basisausführungsbeispiel erst einmal nicht eingegangen wird. Die erste Schaltungslage 12 ist beispielsweise die obere Schaltungslage, während die Schaltungslage 14 die untere Schaltungslage ist. Die obere Schaltungslage 12 ist mit einer zweiten Hauptoberfläche 12h2, das heißt also mit ihrer Unterseite mit der zweiten Schaltungslage 14 verbunden. Hier ist die zweite Hauptoberfläche 12h2 der ersten Schaltungslage mit der ersten Hauptoberfläche 14h1 der zweiten Schaltungslage 14 verbunden. Die Hauptoberfläche 12h2 ist die Frontseite der ersten Schaltungslage 12, während die Schaltungslage 14h1 als Rückseite der zweiten Schaltungslage 14 bezeichnet werden kann. Die Frontseite der zweiten Schaltungslage 14 ist mit dem Bezugszeichen 14h2 versehen. Durch die beschriebene Anordnung ergibt sich eine sogenannte Face-to-Back-(Frontseite zu Rückseite)Anordnung der zwei Schaltungslagen 12 und 14, so dass ein 3D-Stapel von Schaltkreisen geformt wird.

Die zwei Schaltungslagen 12 und 14 können selbstverständlich in sich auch mehrere Schichten von Bereichen, wie z. B. Halbleiterbereichen, dotierten Bereichen, isolierenden Bereichen oder leitenden Bereichen (Metallisierungsschicht) aufweisen, um so die elektrischen Bauelemente, die für die jeweilige Schaltungslage 12 und 14 vorgesehen ist, herzustellen. Das Bauteil bzw. die Schaltungslage 12 umfasst beispielsweise einen oder mehrere integrierte Schaltkreise 12i, die z. B. eine Logik oder einen Speicher formen. Die gesamte Schaltungslage 12 ist entsprechend Ausführungsbeispielen mit einer Herstellungstechnologie, wie z. B. der 3-nm-Halbleiterherstellungstechnologie hergestellt, so dass man die Schaltungslage 12, die beispielsweise ein gemeinsames Halbleitermaterial (in unterschiedlichen Schichten) aufweist als ein Bauelement oder auch als einen Chip bezeichnet werden kann.

Die Schaltungslage 14 umfasst eine Stromversorgung 14s, z. B. einen DC-DC-Konverter. Die Stromversorgung 14 dient dazu, die integrierte Schaltung 12i mit einer entsprechend stabilisierten Spannung zu versorgen. Beispielsweise ist die Stromversorgung 14s über Kontakte 14sk an der Oberfläche 14h1 mit einer optionalen Umverdrahtungsschicht 12u der Schaltungslage 12 elektrisch gekoppelt. Dadurch entstehen sehr kurze Leitungslängen, was vorteilhaft für die stabilisierte Spannung ist. Indem die Stromversorgung 14s in einem separaten Bauteil bzw. einer separaten Schaltungslage 14 hergestellt ist, kann hier eine andere Herstellungstechnologie im Vergleich zu der Schaltungslage 12 verwendet werden, z.B. eine ältere Schaltungstechnologie oder allgemein eine die vorteilhaft für die Herstellung von Bauelementen für die Stromversorgung ist.

Das Ausführungsbeispiel kann also dahin gehend beschrieben werden, dass mittels Face-to-Back-Anordnung zwei Schaltungslagen 12 und 14 miteinander verbunden werden. Für die Verbindung kann beispielsweise die Direct-Bond-Technologie (Direktbonden bzw. allgemein Bonden) oder auch der Einsatz von Copper-Pillow (Kupferverbindungskissen bzw. allgemein Verbindungskissen) verwendet werden.

An dieser Stelle sei angemerkt, dass entsprechend Ausführungsbeispielen die Stromversorgung 14s einen oder mehrere DC-DC-Konverter aufweisen kann. Da man beispielsweise davon ausgeht, dass die Stromversorgung 14s von der Unterseite 14h2 (zweite Hauptoberfläche) mit unregulierter Spannung versorgt wird, kann der DC-DC-Konverter 14s eine Spannungsregulierung derart durchführen, dass eine stark angepasste Spannung ohne große Schwankungen mit ausreichender elektrischer Energie bereitgestellt wird. Die unregulierte Spannung kann beispielsweise über die Kontaktanschlüsse 14sk2 angelegt werden.

Darüber hinaus kann entsprechend weiteren Ausführungsbeispielen die Schaltungslage 14 eine oder mehrere Durchkontaktierungen (tsv) aufweisen, die beispielsweise mit dem Bezugszeichen 14tsv markiert sind. Diese dienen beispielsweise dazu, eine direkte Verbindung (elektrische Verbindung) von der zweiten Hauptoberfläche 14h2 zu der ersten Hauptoberfläche 14h1 herzustellen. Hierdurch kann ein Signal von der Außenseite an die integrierte Schaltung 12i angelegt werden. Signal-Vias sind mit dem Bezugszeichen 14tsvs gekennzeichnet.

Entsprechend einem weiteren Ausführungsbeispiel kann eine weitere Schaltungslage 16, z. B. auf der ersten Hauptoberfläche 12h1 (Oberseite) angeordnet sein. Diese ist wiederum mit ihrer Unterseite 16h2 (zweite Hauptoberfläche) angeordnet und kann entsprechend Ausführungsbeispielen eine integrierte Schaltung, wie z. B. eine Logik oder einen Speicher (nicht dargestellt) umfassen. Bei den hier vorliegenden Ausführungsbeispielen kann die Unterseite 16h2, 14h2 und 12h2 dadurch gekennzeichnet sein, dass diese eine Umverdrahtungsschicht 12u, 16u oder 14u aufweist. Die Umverdrahtungsschicht dient zur elektrischen Kontaktierung der einzelnen Bauelemente im Halbleiterbereich und kann beispielsweise als Metallisierung ausgeführt sein. Anstelle der Umverdrahtungsschicht kann natürlich auch eine Art Transistorschicht vorgesehen sein, wobei hier beispielsweise auch Teile der Transistoren im Halbleiterbereich geformt sein können. Die Umverdrahtungsschicht dient beispielsweise auch zur Kontaktierung von extern, wie insbesondere anhand der Umverdrahtungsschicht 14u deutlich wird.

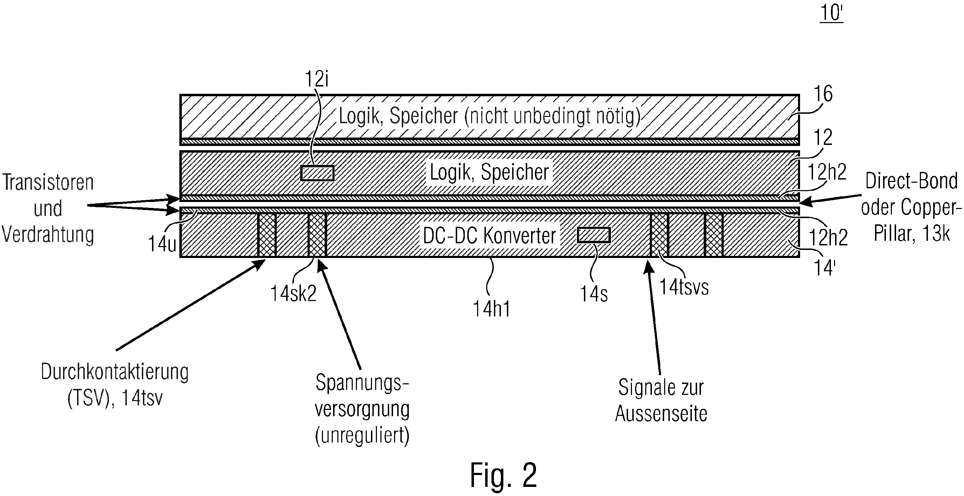

Nachfolgend wird Bezug nehmend auf Fig. 2 ein weiteres Ausführungsbeispiel erläutert.

Fig. 2 zeigt ein Halbleiterbauelement 10' mit wiederum zwei Schaltungslagen 12 und 14'sowie einer optionalen Schaltungslage 16. Die Schaltungslage 12 entspricht im Wesentlichen der Schaltungslage 12 aus Fig. 1 und umfasst beispielsweise die integrierte Schaltung 12i.

Die Schaltungslage 12 ist über ihre zweite Hauptoberfläche 12h2 mit der Schaltungslage 14' verbunden. Die Schaltungslage 14' ist vom Grundsatz her vergleichbar mit der Schaltungslage 14 aus Fig. 1 und weist beispielsweise ebenfalls den DC-Konverter 14s als Stromversorgung auf. In diesem Ausführungsbeispiel ist die Schaltungslage 14' allerdings nicht mit der Hauptoberfläche 14h1, sondern mit der Hauptoberfläche 14h2 mit der Schaltungslage 12 verbunden. Wie hier eingangs erwähnt, kann diese zweite Hauptoberfläche 14h2 beispielsweise die Umverdrahtungsschicht 14u aufweisen.

Diese Anordnung wird als Face-to-Face-Anordnung bezeichnet. Mit dieser Anordnung ist wiederum der Weg vom DC-DC-Konverter 14s zu der eigentlichen Schaltung 12i extrem kurz. Ebenfalls kann der DC-DC-Konverter 14s in einer älteren Schaltungstechnologie gefertigt werden. Damit wird das System von der Unterseite (Seite der Schaltungslage 14) mit einer unregulierten Spannung versorgt, vgl. Anschlüsse 14sk2, wobei die Spannungsregulierung in dem Schaltkreis mit dem DC-DC-Konverter 14h2 erfolgt. Die "normalen" Signale des Schaltkreises mit der Logik und dem Speicher 12i werden unter Verwendung der Vias 14tsvs durch den Schaltkreis 14' mit dem DC-DC-Wandler 14s nach außen geführt.

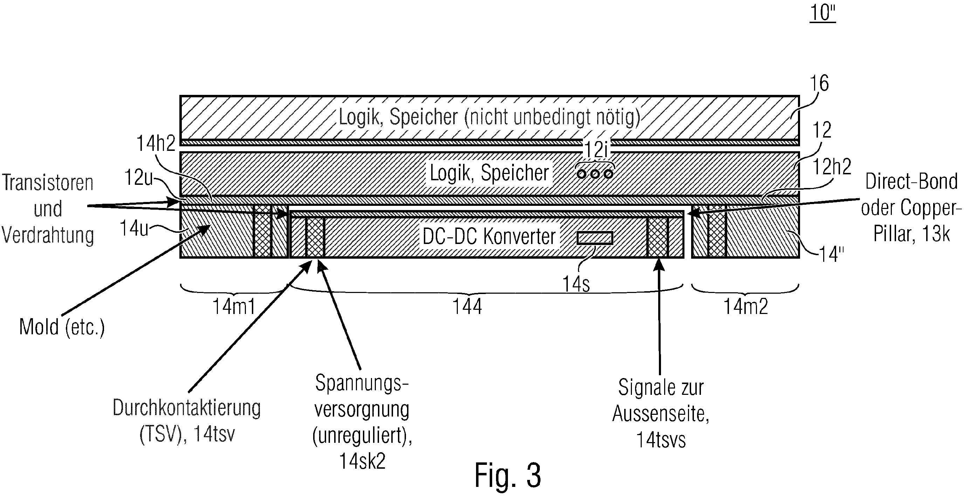

Bezug nehmend auf Fig. 3 wird eine sogenannte Face-to-Face-Anordnung mit einem Mold erläutert. Fig. 3 zeigt die Halbleiteranordnung 10" mit den Schaltungslagen 12, 14" und der optionalen Schaltungslage 16.

Die Schaltungslage 14" ist eine weitere Entwicklung der Schaltungslage 14' und weist neben dem Halbleitermaterial bzw. dem ersten Material im Bereich der Spannungsversorgung 14s ein weiteres Material auf. Dieses weitere Material ist hier mit dem Bezugszeichen 14m1 und 14m2 gekennzeichnet und kann beispielsweise ein Mold-Material umfassen. Die Schicht 14" ist wiederum mit ihrer zweiten Hauptoberfläche 14h2 mit der zweiten Hauptoberfläche 12h2 der ersten Schaltungslage 12 gekoppelt.

Insofern wird durch das hier dargestellte Ausführungsbeispiel eine sogenannte Face-to-Face-Anordnung mit Mold-Anordnung geschaffen. Die Leitungslänge vom DC-DC-Konverter "normalen" Schaltung 12i ist weiterhin extrem kurz. Ferner bleibt auch sichergestellt, dass der DC-DC-Konverter 14 bzw. die allgemeine Stromversorgung 14s mit einer älteren Schaltungstechnologie bzw. einer angepassten Schaltungstechnologie gefertigt werden kann.

Ab dieser Stelle sein angemerkt, dass sowohl das Halbleiterbauelement 10' aus Fig. 2 als auch das Halbleiterbauelement 10" aus Fig. 3 ebenso die weiteren Merkmale Vias 14tsv bzw. 14tsvs und Spannungskontakte 14sk2 aufweisen kann. Wie anhand des Ausführungsbeispiels aus Fig. 3 zu erkennen ist, können sich die Vias 14tsv im Mold-Material 14m1 und 14m2 erstrecken, wobei selbstverständlich auch eine Erstreckung durch das Halbleitermaterial 14h denkbar wäre. Beispielsweise erstrecken sich hier die Spannungsversorgungs-Vias, vgl. Kontakt 14sk2 durch das Halbleitermaterial 14h bis zu der Umverdrahtungsschicht 14u, so dass über diese Umverdrahtungsschicht 14u die unregulierte Spannung der Stromversorgung 14s bereitgestellt wird, wobei dann die Stromversorgung 14s die Spannung entsprechend reguliert.

Erwähnenswert ist, dass bei den Vias 14tsv bzw. 14tsvs, die sich aus dem Mold-Material 14m1 und 14m2 erstrecken, die Vias 14tsv bzw. 14tsvs bis zu der Umverdrahtungsschicht 12u ragen, während die Vias 12sk2, die sich durch das Halbleitermaterial 14h erstrecken bis zu der Umverdrahtungsschicht 14u ragen. Im Ausführungsbeispiele aus Fig. 2 erstrecken sich alle Vials beispielsweise bis zu der Umverdrahtungsschicht 14u (vgl. 14tsv, 14tsvs, 14sk2).

Bei allen obigen Ausführungsbeispielen aus Fig. 1 bis 3 können die zwei Schaltungslagen 12 und 14 mittels Direktbonden oder Copper Pillows verbunden sein. Ein Copper Pillow ist mit dem Bezugszeichen 13k versehen. An dieser Stelle sei aber auch angemerkt, dass andere Verbindungsmöglichkeiten denkbar wären.

Alle Ausführungsbeispiele haben gemein, dass durch die neuartige Package-Technologie 3D-Integration sehr kompakte Realisierungen für verschiedene Komponenten in einem Chipstapel möglich werden. Dazu werden bei der 3D-Integration Schaltkreise übereinandergestapelt. In diesem Fall ist das einer oder mehrere der Schaltkreise, die mit der eigentlichen (Logik- oder Speicher)-Funktion versehen sind und als 3D-Stapel aufgebaut ist. Externe Komponenten, bei der andere Anforderungen vorliegen, wie z. B. die Spannungsversorgung 14s kann in eine weitere Schaltungsschicht ausgelagert sein.

An dieser Stelle sei angemerkt, dass man bei obigem Ausführungsbeispiel immer von zwei bzw. drei Schaltungslagen ausgegangen ist, wobei selbstverständlich auch mehrere Schaltungslagen (d. h. mehr als drei) denkbar wären. Gerade die optionalen Schaltungslagen 16 können auch gedreht gegenüber den anderen Schaltungslagen 12 und 14 (bzw. 14' bzw. 14") angeordnet sein. Bei obigem Ausführungsbeispiele wurde immer davon ausgegangen, dass die zweite Schaltungslage 14 entweder mit der Schicht 14h1 oder mit der Schicht 14h2 (vgl. Schaltungsaufbau 10' bzw. 10"). Aufseiten der ersten Schaltungslage 12 wird hier immer die Hauptoberfläche 12h2 verwendet. Entsprechend weiteren Ausführungsbeispielen wäre eine Ankopplung über die Hauptoberfläche 12h1 zu der zweiten Schaltungslage 14 auch denkbar, wobei die Verbindung über die Hauptoberfläche 12h2 den Vorteil hat, dass hier die Umverdrahtungsschicht 12u vorgesehen ist, über welche die Versorgungsspannung gut den integrierten Schaltungen 12i zugeführt werden kann.

Anwendungen für die oben erläuterte 3D-Integration sind Halbleiterbauelemente, die zumindest bereichsweise ein Halbleitermaterial, wie z. B. ein Silizium oder ein Galliumarsenid aufweisen können. Von dem Funktionsfokus sind die Anwendungen nicht eingeschränkt, d. h. also, dass jegliche Bauelemente, seien es Speicherbauelemente oder Prozessoren (Logiken) als potenzielle Anwendungsgebiete für die 3D-Integration möglich sind.

Weitere Ausführungsbeispiele beziehen sich auf ein Herstellungsverfahren der oben erläuterten Ausführungsbeispiele 10, 10', 10". Das Herstellungsverfahren umfasst den zentralen Schritt des Verbindens der ersten und zweiten Schaltungslage 12 und 14 bzw. 12 und 14' bzw. 12 und 14", d. h. also mit Face-to-Back-Technologie, Face-to-Face-Technologie oder Face-to-Face-Technologie mit Mold. Das Verbinden kann, wie oben bereits erläutert, mittels Kontaktierungskissen oder Kupferkontaktierungskissen, aber auch mit Bonden oder Direktbonden erfolgen.

Auch wenn Ausführungsbeispiele insbesondere im Zusammenhang mit einer Vorrichtungen (Halbleiterbauelement, 3D-Schichtstapel oder Chip) erläutert wurden, sei darauf hingewiesen, dass die Erläuterungen der einzelnen Produktmerkmale gleichzeitig die Erläuterungen des entsprechenden Verfahrensschritts darstellen können. Umgekehrt kann die Erläuterung zum Verfahrensschritt auch als Erläuterung zu einem Produktschritt gewertet werden. Der Schutzbereich wird durch die nachfolgenden Patentansprüche definiert.

## Patentansprüche

1. Halbleiterbauelement (10, 10', 10") mit folgenden Merkmalen:
erster Schaltungslage (12) mit zumindest einer integrierten Schaltung; und
zweiter Schaltungslage (14, 14', 14") mit zumindest einer Stromversorgung (14s), die ausgebildet ist, die integrierte Schaltung (12i) mit elektrischer Energie zu versorgen;
wobei eine zweite Hauptoberfläche (12h2) der ersten Schaltungslage (12) mit einer ersten oder zweiten Hauptoberfläche (14h2) der zweiten Schaltungslage (14, 14', 14") verbunden ist.

2. Halbleiterbauelement (10, 10', 10") gemäß Anspruch 1, wobei die Verbindung der zweiten Hauptoberfläche (12h2) der ersten Schaltungslage (12) mit der ersten oder zweiten Hauptoberfläche (14h2) der zweiten Schaltungslage (14, 14', 14") eine direkte Verbindung, eine direkt-gebondete Verbindung, eine gebondete Verbindung, eine Verbindung mit einem Kontaktierungskissen (13k) oder eine Verbindung mit einem Kupferkontaktierungskissen umfasst.

3. Halbleiterbauelement (10, 10', 10") gemäß einem der vorherigen Ansprüche, wobei die integrierte Schaltung (12i) eine Logik/oder einen Speicher umfasst.

4. Halbleiterbauelement (10, 10', 10") gemäß einem der vorherigen Ansprüche, wobei die Stromversorgung (14s) einen DC-DC-Konverter umfasst.

5. Halbleiterbauelement (10, 10', 10") gemäß einem der vorherigen Ansprüche, wobei die zweite Schaltungslage (14, 14', 14") die Fläche der ersten Schaltungslage (12) bedeckt; und/oder
wobei die zweite Schaltungslage (14, 14', 14") über die Breite der ersten Schaltungslage (12) ein Halbleitermaterial aufweist.

6. Halbleiterbauelement (10, 10', 10") gemäß einem der Ansprüche 1 bis 4, wobei die zweite Schaltungslage (14, 14', 14") einen ersten Bereich mit einem Halbleitermaterial und mindestens einen zweiten Bereich mit einem Mold-Material (14m1, 14m2) aufweist, wobei sich der erste und der zweite Bereich über die Breite der ersten Schaltungslage (12) erstrecken.

7. Halbleiterbauelement (10, 10', 10") gemäß einem der vorherigen Ansprüche, wobei die erste Hauptoberfläche (14h1) der zweiten Schaltungslage (14, 14', 14") Kontakte aufweist, wenn die zweite Hauptoberfläche zur Verbindung mit der ersten Schaltungslage (12) dient, oder wobei die zweite Hauptoberfläche (14h2) der zweiten Schaltungslage (14, 14', 14") Kontakte aufweist, wenn die erste Hauptoberfläche zur Kontaktierung mit der ersten Schaltungslage (12) dient.

8. Halbleiterbauelement (10, 10', 10") gemäß Anspruch 7, wobei die Kontakte (14sk2) ausgebildet sind, um mit einer ungeregelten Spannungsquelle verbunden zu werden; und/oder wobei die Stromversorgung (14s) ausgebildet ist, ausgehend von einer anliegenden ungeregelten Spannung einer ungeregelten Spannungsquelle eine geregelte Spannung aufseiten der zweiten Hauptoberfläche (12h2) der ersten Schaltungslage (12) zur Stromversorgung (14s) für die integrierte Schaltung (12i) bereitzustellen.

9. Halbleiterbauelement (10, 10', 10") gemäß einem der folgenden Ansprüche, wobei die zweite Schaltungslage (14, 14', 14") ein oder mehrere Vias (14tsv, 14tsvs) aufweist, die sich über die Dicke der zweiten Schaltungslage (14, 14', 14") erstrecken und ausgebildet sind, um einen Signalkontakt der integrierten Schaltung zu schaffen.

10. Halbleiterbauelement (10, 10', 10") gemäß Anspruch 9, wobei sich die ein oder mehrere Vias (14tsv, 14tsvs) durch ein Halbleitermaterial der zweiten Schaltungslage (14, 14', 14") und/oder durch ein Mold-Material (14m1, 14m2) der zweiten Schaltungslage (14, 14', 14") erstrecken.

11. Halbleiterbauelement (10, 10', 10") gemäß einem der vorherigen Ansprüche, wobei die zweite Hauptoberfläche (12h2) der ersten Schaltungslage (12) und/oder die zweite Hauptoberfläche (14h2) der zweiten Schaltungslage (14, 14', 14") eine Umverdrahtungsschicht und/oder eine Bauteilschicht aufweist.

12. Halbleiterbauelement (10, 10', 10") gemäß einem der vorherigen Ansprüche, wobei auf einer ersten Hauptoberfläche (12h1) der ersten Schaltungslage (12) eine weitere Schaltungslage mit einem integrierten Schaltkreis, einer Logik und/oder einem Speicher angeordnet ist.

13. Halbleiterbauelement (10, 10', 10") gemäß einem der vorherigen Ansprüche, wobei die integrierte Schaltung (12i) der ersten Schaltungslage (12) mit einer ersten Halbleiterherstellungstechnologie hergestellt ist und wobei die zumindest eine Stromversorgung (14s) der zweiten Schaltungslage (14, 14', 14") mit einer zweiten Halbleiterherstellungstechnologie hergestellt ist; und
wobei sich die erste Herstellungstechnologie von der zweiten Herstellungstechnologie unterscheidet und/oder wobei die erste Halbleiterherstellungstechnologie eine 3-nm-Technologie oder besser umfasst.

14. Herstellungsverfahren zur Herstellung eines Halbleiterbauelements (10, 10', 10") gemäß einem der vorherigen Ansprüche, wobei das Herstellungsverfahren den Schritt des Verbindens der ersten Schaltungslage (12) mit der zweiten Schaltungslage (14, 14', 14") aufweist.

15. Herstellungsverfahren gemäß Anspruch 14, wobei das Verbinden durch Bonden, Direktbonden oder Herstellen einer Kontaktierungskissenverbindung oder KupferKontaktierungskissenverbindung erfolgt.

16. Herstellungsverfahren gemäß Anspruch 15 oder 16, wobei das Verbinden mittels Face-to-Back-Technologie oder Face-to-Face-Technologie erfolgt.
